(19) Europäisches Patentamt
European Patent Office
Office européen des brevets

(11) EP 0 940 856 B1

(12) EUROPEAN PATENT SPECIFICATION

(45) Date of publication and mention of the grant of the patent:
**11.06.2008 Bulletin 2008/24**

(21) Application number: **98919659.7**

(22) Date of filing: **18.05.1998**

(51) Int Cl.:
***H01L 29/788*** (2006.01) ***H01L 21/8247*** (2006.01)

(86) International application number:
**PCT/JP1998/002207**

(87) International publication number:
**WO 1998/053506 (26.11.1998 Gazette 1998/47)**

# (54) FERROELECTRIC MEMORY ELEMENT AND METHOD OF PRODUCING THE SAME

FERROELEKTRISCHES SPEICHERELEMENT UND VERFAHREN ZUR HERSTELLUNG

ELEMENT DE MEMOIRE FERROELECTRIQUE ET SON PROCEDE DE PRODUCTION

(84) Designated Contracting States:
**DE FR GB NL**

(30) Priority: **23.05.1997 JP 13396597**

(43) Date of publication of application:
**08.09.1999 Bulletin 1999/36**

(73) Proprietor: **ROHM CO., LTD.**
**Kyoto-shi, Kyoto 615-0045 (JP)**

(72) Inventors:
- **NAKAMURA, Takashi**
**Ukyo-ku**
**Kyoto-shi**
**Kyoto 615-0045 (JP)**
- **FUJIMORI, Yoshikazu**
**Ukyo-ku**
**Kyoto-shi**
**Kyoto 615-0045 (JP)**

(74) Representative: **Beresford, Keith Denis Lewis et al**
**BERESFORD & Co.**
**16 High Holborn**
**London WC1V 6BX (GB)**

(56) References cited:
**JP-A- 9 213 899** **US-A- 5 365 094**

- **FUIERER P A ET AL: "Physical electricl and piezoelectric properties of hot-forged Sr/sub 2/ (NbTa)/sub 2/O/sub 7/ ceramics" SMART MATERIALS FABRICATION AND MATERIALS FOR MICRO-ELECTRO-MECHANICAL SYSTEMS, SAN FRANCISCO, CA, USA, 28-30 APRIL 1992, pages 51-57, XP008000252 1992, Pittsburgh, PA, USA, Mater. Res. Soc, USA**
- **PRASADARAO A V ET AL: "Fabrication of Sr/sub 2/Nb/sub 2/O/sub 7/ thin films by sol-gel processing" JOURNAL OF MATERIALS RESEARCH, MARCH 1995, USA, vol. 10, no. 3, pages 704-707, XP008000250 ISSN: 0884-2914**
- **KAKIHANA M ET AL: "A simple solution route to the synthesis of pure La2Ti2O7 and Nd2Ti2O7 at 700-800 DEG C by polymerized complex method" JOURNAL OF ALLOYS AND COMPOUNDS, ELSEVIER SEQUOIA, LAUSANNE, CH, vol. 242, 15 September 1996 (1996-09-15), pages 6-10, XP004080407 ISSN: 0925-8388**
- **THE 43TH PREPRINTS OF THE JOINT CONGRESS OF APPLIED PHYSICS, (1996), No. 2, p. 409, XP002917247**
- **TECHNICAL RESEARCH REPORT OF IEICE, (1993), Vol. 93, No. 350, p. 53-59, XP002917248**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 0 940 856 B1

## Description

The present invention relates to a ferroelectric memory device, and a method of manufacturing such ferroelectric memory device.

Field effect transistors (FETs) using ferroelectric thin film are proposed as nonvolatile memory devices. An example of an FET using a PZT ($PbZr_x Ti_{1-x}O_3$) is shown in Fig. 13. The FET 12 shown in Fig. 13 is a kind of FET having a so called MFMIS (Metal Ferroelectric Metal Insulator Silicon) structure. The FET 12 is formed by means of disposing a gate oxidation layer 4, a floating gate 6, a ferroelectric thin film 8, and a control gate 10 in that order on a channel region CH formed in a semiconductor substrate 2.

The polarization of the ferroelectric thin film 8 is inverted when a positive voltage +V is applied to the control gate 10 while grounding the substrate 2 of the FET 12 (an N channel substrate). Negative electric charges are established in the channel region CH as a result of a remanence polarization remaining in the ferroelectric thin film 8 even when the positive voltage +V is no longer applied to the control gate 10. A condition that the negative electric charges are in the channel region CH corresponds to data "1".

Conversely, occurrence of another polarization reversal in the opposite polarity is observed when a negative voltage -V is applied to the control gate 10. Positive electric charges are generated in the channel region CH as a result of a remanence polarization remaining in the ferroelectric thin film 8 even when the negative voltage -V is no longer applied to the control gate 10. Another condition that the positive electric charges are in the channel region CH corresponds to data "0". Either of data "1" or data "0" is stored in the FET 12 by carrying out the procedures described above.

In order to read out the data being stored therein, a readout voltage Vr is applied to the control gate 10. The readout voltage Vr is set at a value between the threshold voltage Vth1 of the FET 12 which is defined when the data "1" is stored and the threshold voltage Vth0 of the FET 12 which is defined when the data "0" is stored. Judgement of the stored data, either in "1" or "0" can be carried out by detecting whether a predetermined drain current flows or not when the readout voltage Vr is applied to the control gate 10. The stored data is not erased in the course of reading out of the data.

Thus, nondestructive readout can be carried out using the FET including a ferroelectric thin film. Further, such a device is capable of composing one memory cell.

However, the FET using the ferroelectric described above has the following problems to be resolved. The FET 12 is considered in a condition that a capacitor Cf (capacity Cf) which includes the ferroelectric thin film 8 and a capacitor Cox (capacity Cox) having the gate oxidation layer 4 is connected in series during the writing (see Fig. 2). Under the circumstances, a divided voltage Vf defined by the following equation is applied to the capacitor Cf when a voltage (equal to either of +V or -V) is applied at a point located between the substrate 2 and the control gate 10,

$$Vf=Cox/(Cf+Cox).V.$$

On the other hand, in order to cause the polarization reversal of the ferroelectric thin film 8 during the writing, the divided voltage Vf needs to be a large value. And, the capacitance of the capacitor Cf should be a small value relative to that of the capacitor Cox as it is clear from the equation shown in above. The relative dielectric constant (200 to 1,000) of the PZT composing the ferroelectric thin film 8 is much higher than the relative dielectric constant (3.9) of the $SiO_2$ which composes the gate oxidation layer 4.

Consequently, it is difficult to increase the divided voltage Vf shown in above. It is therefore, not easy to cause polarization reversal of the ferroelectric thin film 8 during the writing. The melting point of PZT is at a low temperature (800 to 900°C) because PZT contains Pb. This leads to lattice defects in an FET requiring heat treatment after forming a ferroelectric thin film. Similar problem to PZT may be observed in a ferroelectric material using bismuth (Bi).

A ferroelectric memory device of the kind shown in Fig. 13 is also known from United States Patent No. 5,365,094, using a ferroelectric thin film of lead titanate: $PbTiO_3$ as storage medium.

The present invention is intended to overcome the above mentioned drawbacks associated with the prior art, and to provide a ferroelectric memory device including a ferroelectric thin film having a low dielectric constant and also a high melting point, which ferroelectric thin film is suitable as a ferroelectric memory element thereof.

It is acknowledged that a study of the physical, electrical, and piezoelectric properties of the $Sr_2 Nb_2 O_7$- $Sr_2 Ta_2 O_7$ system for thick film and bulk samples is reported by Fuierer P A et al "Physical electric and piezoelectric properties of hot-forged Sr/sub2/(NbTa)/sub 2/O/sub 7/ceramics" SMART MATERIALS FABRICATION AND MATERIALS FOR MICRO-ELECTRO-MECHANICAL SYSTEMS, SAN FRANCISCO, CA, USA, 28-30 APRIL 1992, pages 51-57, XP008000252 1992, Pittsburgh, PA, USA, Mater. Res. Soc, USA.

Also, in accordance with the present invention there is provided a method of manufacturing a ferroelectric memory device, including producing a ferroelectric thin film by performing ordered steps of:

(a) coating a base with mixed-metal alkoxide of Sr, Ta, and Nb dissolved in a solvent;
(b) evaporating the solvent;
(c) removing the organic elements of the residue by heat treatment; and,
after performing steps (a) to (c) one or more times to form an amorphous thin film having a desired thickness:
(d) annealing said amorphous thin film at a temperature above crystallization point to form a thin film of said mixed crystal defined by said formula: $Sr_2\ (Ta_{1-x}\ Nb_x)_2O_7$; $0.1 \le x \le 0.3$.

The invention will be better understood and appreciated, from the detailed description given below taken in conjunction with the accompanying drawings wherein:

Fig. 1 is a view showing a construction of an FET 20 having an MFMIS structure which forms a ferroelectric memory device in an embodiment of the present invention;

Fig. 2 is a diagram showing an equivalent circuit of the FET 20 during the writing.

Fig. 3 is a graph showing a relationship between thicknesses tf of a ferroelectric thin film 28 and electric fields Ef applied to a capacitor Cf;

Fig. 4A is a graph being drawn according to plots showing a relationship between k1 and k2 of major ferroelectric substances;

Fig. 4B is an enlarged view of an area (z) of the graph shown in Fig. 4A;

Fig. 5 is a graph showing x-ray diffraction patterns of a memory device being fabricated.

Fig. 6 is a table showing both crystallographical and electric characteristics of $Sr_2Nb_2O_7$ and $Sr_2Ta_2O_7$;

Fig. 7 is a graph showing a relationship between mixture ratios x of Nb in a mixed crystal $Sr_2\ (Ta_{1-x}Nb_x)\ _2O_7$ and Curie temperature Tc of the mixed crystal;

Fig. 8 is a graph showing the x-ray diffraction patterns of the memory device having a ratio x of 0.3;

Fig. 9 is a graph showing a relationship between voltages applied to a thin film made of $Sr_2\ (Ta_{1-x}\ Nb_x)\ _20_7$ and polarization states generated therein;

Fig. 10 is a graph showing a relationship between bias voltages applied to the thin film of $Sr_2\ (Ta_{1-x}Nb_x)\ _2O_7$ and capacitances thereof;

Fig. 11 is a graph showing leakage current characteristics of the thin film of $Sr_2\ (Ta_{1-x}Nb_x)\ _20_7$.

Fig. 12A is a view showing a structure of an FET in another embodiment of the present invention.

Fig. 12B is a view showing a structure of an FET in far another embodiment of the present invention;

Fig. 12C is a view showing a structure of an FET in still another embodiment of the present invention;

Fig. 13 is a view of an FET using the conventional ferroelectric thin film.

A view showing a construction of an FET 20 having an MFMIS structure which forms a ferroelectric memory device in an embodiment of the present invention is depicted in Fig. 1. The FET 20 comprises a source region S and a drain region D, both formed in a semiconductor substrate 22 made of silicon. A channel region CH is formed between the source region S and the drain region D.

A gate oxidation layer 24 acts as an insulation layer is formed on the channel region CH. The gate oxidation layer 24 is made of SiO2. A floating gate 26 forming a lower conductive layer is formed on the gate oxidation layer 24. The floating gate 26 has a stacked structure of Pt/IrO2.

On the floating gate 26, a ferroelectric thin film 28 described later is disposed. A control gate 30 acts as an upper conductive layer is formed on the ferroelectric thin film 28. The control gate 30 is made of Pt.

Next, an equivalent circuit of the FET 20 during the writing is diagrammed in Fig. 2. The equivalent circuit of the FET 20 during the writing is in a formation of connecting a capacitor Cf (capacity Cf) which includes the ferroelectric thin film 28 and a capacitor Cox (capacity Cox) having the gate oxidation layer 24 in series. Under the circumstances, a divided voltage Vf defined by the following equation is applied to the capacitor Cf when a voltage (equal to either of +V or -V) is applied at a point located between the substrate 22 and the control gate 30,

$$Vf=Cox/(Cf+Cox).V.$$

An electric field Ef applied to the capacitor Cf is defined as the following expression when the area of the capacitor Cf and that of the capacitor Cox is set as the same with each other,

$$\epsilon f= \epsilon ox/(\epsilon f.tox+\epsilon ox.tf).V \qquad ...(1)$$

wherein εf is a relative dielectric constant of a ferroelectric substance, εox represents a relative dielectric constant of $SiO_2$, tf is a thickness of the ferroelectric thin film, and tox represents a thickness of the gate oxidation layer.

In order to cause a polarization reversal in the opposite polarity within the ferroelectric thin film 28, the following expression must be satisfied,

$$Ef>\alpha Ec \ (2) \qquad ...(2)$$

wherein αEc represents an electric field required for causing a polarization reversal, alpha is a constant, and Ec represents coercive field.

The following expression is obtained according to the expressions (1) and (2),

$$\epsilon ox/(\epsilon f.tox+\epsilon ox.tf).V>\alpha Ec \qquad ...(3)$$

In order to increase the value of the left member of the expression (3) that is the electric field Ef applied to the capacitor Cf, either ways of decreasing the relative dielectric constant ef or making the thickness tf of the ferroelectric thin film 28 and/or the thickness tox of the gate oxidation layer 24 thinner should be taken. However, there is a limitation of making the thickness tox of the gate oxidation layer 4 thinner.

Fig. 3 is a graph showing a relationship between thicknesses tf of a ferroelectric thin film 28 and electric fields Ef applied to the capacitor Cf when the thickness tox of the gate oxidation layer 24 is fixed to 10nm as well as using voltages V applied at a point located between the substrate 22 and the control gate 30 as a parameter. Solid curves show the relationship when the relative dielectric constant εf the ferroelectric substance is 10, dashed curves illustrate the relationship when the relative dielectric constant εf of the ferroelectric substance is 100.

As it is understood from Fig. 3, no significant increase of the electric fields εf is observed when the relative dielectric constant εf of the ferroelectric substance is 100 even if the thickness tf of the ferroelectric thin film 28 is made thinner. On the contrary, significant increase of the electric fields εf is observed when the relative dielectric constant εf of the ferroelectric substance is 10 in the case of making the thickness tf of the ferroelectric thin film 28 thinner. In other words, it is necessary to make the thickness tf of the ferroelectric thin film 28 thinner while decreasing the relative dielectric constant εf in order to increase the electric fields Ef.

The expression (3) may be formulized in another expression shown in below,

$$V/\alpha>Ec.\epsilon f/Eox.tox+tf=kl \qquad ...(4)$$

In order to cause a polarization reversal in the opposite polarity within the ferroelectric thin film 28, the expression (4) must be satisfied.

Next, electric fields Eox being generated in accordance with a divided voltage Vox applied to a capacitor Cox including the gate oxidation layer 24 can be defined by the following expression,

$$Eox= \epsilon f/\epsilon ox.Ef.$$

The expression shown above may be expressed as below when the electric field alpha εc representing the electric field required for causing the polarization reversal is applied to the capacitor Cf as the electric field εf,

$$Eox= \epsilon f/\epsilon ox.\alpha Ec \quad ...(5)$$

On the other hand, in order to prevent dielectric breakdown of the gate oxidation 24, the following expression must be satisfied,

$$Eox<Ebd \quad ...(6)$$

wherein Ebd represents strength of the dielectric breakdown of the gate oxidation layer 24.

The following expression is obtained according to the expressions (5) and (6),

$$Ebd.\ \epsilon ox/\alpha>Ec.\ \epsilon f=k2 \quad ...(7)$$

In order words, the expression (7) shown in above must be satisfied in order to prevent dielectric breakdown of the gate oxidation layer 24.

Fig. 4A is a graph being drawn according to plots showing a relationship between k1 used in the expression (4) and k2 used in the expression (7) of major ferroelectric substances. In the graph, some of the values used in these expressions are defined as the followings,
tox=15nm,
εox=3.9, and
tf=200nm.

Another expression shown in below is introduced according to the expression (4),

$$2.5[v]>k1 \text{ when} \quad ...(8),$$

when values used in the expressions are defined as below,

V=5.0V,
a=2,
Ebd=8MV/cm, and
εox=3.9.

Further, another expression is defined as below according to the expression (7),

$$1.56X10^{9}\ [V/m]>k2 \quad ...(9)$$

Both the expressions (8) and (9) need to be satisfied in order to cause the polarization reversal of the ferroelectric thin film 28 as well as preventing the dielectric breakdown of the gate oxidation layer 24.

The ferroelectric substances, these located in an area (z) illustrated with a dot line shown in Fig. 4A satisfy the requirements stated above. Fig. 4B is an enlarged view illustrating the vicinity of the area (z).

Further, in order to form the source S and the drain D shown in Fig. 1 by means of self aligning, thermal diffusion of implanted impurities need to be carried out, the impurities being implanted using the ferroelectric thin film 28 as a mask after forming the ferroelectric thin film 28. Therefore, the ferroelectric thin film 28 should be composed of a ferroelectric substance having a high melting point which withstands heat treatments carried out in the vicinity of 800°C.

Among a variety of ferroelectric substances, $Sr_2Nb_2O_7$ is selected as a ferroelectric substance which satisfies the requirements described in above. A thin film made of $Sr_2Nb_2O_7$ is formed using the Sol-Gel method described later. Fig. 5 is a graph showing x-ray diffraction patterns of a memory device being fabricated using annealing temperatures for crystallization as a parameter. As clearly can be recognized from Fig. 5, the peaks show unique characteristics of $Sr_2Nb_2O_7$ on the graph when the annealing temperature is equal to or more 900°C, so that, it is understood that the $Sr_2Nb_2O_7$ is crystalline.

The relative dielectric constant $\varepsilon f$ of the thin film made of $Sr_2Nb_2O_7$ thus obtained is measured to be in the vicinity of 45. It is, however, not possible to confirm ferroelectricity (hysteresis characteristics between the voltage applied thereto and the polarization therein) of the film. A Curie temperature Tc of the thin film is considered as one of the reasons. Curie temperature is a temperature located at the boundary between temperatures in which a substance indicates ferroelectricity and temperatures in which the substance shows dielectricity. In this connection, the substance indicates ferroelectricity when the temperature of the substance is lower than its Curie temperature. It is expected that the thin film made of $Sr_2Nb_2O_7$ would show ferroelectricity at room temperature according to the principles of crystallographic, because the Curie temperature Tc of $Sr_2Nb_2O_7$ is at 1342°C.

However, no vibrations of their lattices are observed (the phenomena is called as "suspension of the soft mode") at the room temperature. It is considered that its high curie temperature prevent the thin film from the vibrations, so that no ferroelectricity is observed at the room temperature. The inventors focus attention on $Sr_2Ta_2O_7$ having the same crystalline structure as that of $Sr_2Nb_2O_7$ and a remarkably lower Curie temperature (Tc = -107°C).

Crystallographical and electric characteristics of $Sr_2Nb_2O_7$ and $Sr_2Ta_2O_7$ are listed on a table shown in Fig. 6. The crystal structure of $Sr_2Nb_2O_7$ and $Sr_2Ta_2O_7$ (both of which have pyramid quadratic structure) is similar to each other. Under the fact, the inventors make a thin film using a mixed crystal made of $Sr_2Nb_2O_7$ and $Sr_2Ta_2O_7$ which satisfies the following condition in experimental basis, that is expressed as the following,

$$Sr_2(Ta_{1-x}Nb_x)_2O_7 \qquad (10)$$

wherein 0<x<1.

The mixed crystal consist of $Sr_2(Ta_{1-x}Nb_x)_2O_7$ changes its crystallographical and electric characteristics consecutively correspond to its mixture ratio. Fig. 7 is a graph showing the relationship between mixture ratios x of Nb in a mixed crystal $Sr_2(Ta_{1-x}Nb_x)_2O_7$ and a Curie temperature of the mixed crystal. It is understood that the mixture ratio x of Nb in the mixed crystal should be xl in order to obtain a Curie temperature of Tcl according to the graph.

Mixed crystals composed of the substance shown in the expression (10) under a plurality of mixture ratio x such as 0.1, 0.2, 0.3, 0.4, and 0.6 are made respectively. Sol-Gel method is used for forming a thin film made of the mixed crystal. Processes for forming a thin film made of the mixed crystal by the Sol-Gel method will be described hereunder.

At first, mixed-metal alkoxide composed of Sr, Ta, and Nb, which is dissolved in a solvent is prepared, and the alkoxide thus dissolved is coated on a base substance (this substance becoming the floating gate 26 as a result of patterning, see Fig. 1) having a stacked structure of $Pt/IrO_2$. In this embodiment, 2-metoxyethernol is used for the solvent. The alkoxide is coated by spin coating method.

The solvent is evaporated at a temperature of 180°C.

Thereafter, in order to remove organic elements, heat treatment using dry air heated at 400°C is carried out for 30 minutes.

An amorphous layer having a predetermined thickness is formed by carrying out these processes repeatedly. In this embodiment, the processes described above are carried out for a total of four times (four coatings). It is not necessary to repeat the processes as described above, the processes may be carried out just once when the predetermined thickness is much thinner than that of above.

Next, annealing for crystallization is carried out to the amorphous layer thus formed. The annealing in this embodiment is carried out by rapid thermal annealing (RTA) method. That is, heat treatment using $O_2$ within a range of 850 to 1000°C is carried out for 1 minute. Thus, the thin film made of the mixed crystal composed of the substance shown in the expression (10) is obtained. The thickness tf of the thin film thus obtained is 145nm.

Although, various temperatures, durations, and other conditions are described above, the present invention is not limited to the conditions, alternative conditions can be used.

Also, the method for forming the thin film made of the mixed crystal composed of $Sr_2(Ta_{1-x}Nb_x)_2O_7$ is not limited to Sol-Gel method. Other available methods conventionally used such as sputtering, MOCVD, MOD, IBS, PLD, and the like can be used for forming the thin film.

Another layer made of Pt (this layer becoming the control gate 30 as a result of patterning, see Fig. 1) is disposed on the thin film thus obtained by carrying out a sputtering method.

Fig. 8 is a graph showing the x-ray diffraction patterns of the memory device having a ratio x of 0.3 using the annealing temperatures for crystallization as a parameter. As it is understood from Fig. 8, the peaks show unique characteristics of $Sr_2(Ta_{1-x}Nb_x)_2O_7$ appeared on the graph when the annealing temperature is equal to or more 950°C, so that, it is understood that $Sr_2(Ta_{1-x}Nb_x)_2O_7$ is in crystallization. In our observation, the surface of the thin film made of $Sr_2(Ta_{1-x}Nb_x)_2O_7$ was very smooth and fine structure in crystallization.

The peaks showing unique characteristics of $Sr_2(Ta_{1-x}Nb_x)_2O_7$ are not observed in the graph when the annealing temperatures are respectively in 850°C and 900°C. Instead of these peaks, other peaks indicating that the substance is in $Sr_2(Ta_{1-x}Nb_x)_{10}O_{27}$ shown in the graph are observed. In our experiment, a relationship between the x-ray diffraction patterns of the memory device and the annealing temperatures are not depending on the values of x within a range of $0.1 \leq x \leq 0.6$

Fig. 9 is a graph showing a relationship between voltages applied to the thin film made of $Sr_2 (Ta_{1-x} Nb_x)_2O_7$ and polarization states generated therein using the value x as a parameter. The relationship between the voltages and the polarization states is measured with a Sawyer tower circuit using a frequency of 1KHz. The axis of abscissas shows the voltages, and the axis of ordinates represents the polarization states. The relationship between the voltages and the polarization states shows hysteresis characteristics when the values of x is in a range of $0.1 \leq x \leq 0.3$ According to Fig. 7, it is understood that Curie temperature Tc of the thin film is in a range of 180°C to 600°C when the values of x are in a range of $0.1 \leq x \leq 0.3$ (As in Fig. 7, the Curie temperatures Tc of the thin film are either in the vicinity of 410°C or 520°C when the values of x are 0.2 and 0.3 respectively).

On the contrary, no hysteresis characteristics are shown when the values of x are 0.4 and 0.6 (not shown). The phenomena might be caused due to high Curie temperature Tc (As in Fig. 7, the Curie temperatures Tc of the thin film are either in the vicinity of 735°C or 1000°C when the values of x are 0.4 and 0.6 respectively).

It is not preferable to set the value of x in an excessively small value because it leads to an undesirable decrease of Curie temperature Tc. As it is understood from Fig. 9, remanent polarization Pr is in the largest value such as 0.5 $\mu c/cm^2$ when the values of x is in 0.3. At that time, coercive field Ec was measured at 44KV/cm.

Fig. 10 is a graph showing a relationship between bias voltages applied to the thin film of $Sr_2 (Ta_{1-x} Nb_x)_2 0_7$ and capacitances thereof using the value x as a parameter. The relationship between the voltages and the capacitances is measured with an LCR meter generating 25mV and 100 KHz (model No. HP4284A). The axis of abscissas shows the bias voltages, and the axis of ordinates represents the capacitances. Sweep rate of the measurement was 0.5V/second. It is clearly understood that the thin film being formed shows hysteresis characteristics when the values of x is in a range of $0.1 \leq x \leq 0.3$.

Relative dielectric constant er of the thin film was 53 when the value x is 0.3, the dielectric constant being calculated from the capacitance when 0V is applied thereto as the bias voltage.

Fig. 11 is a graph showing leakage currents of the thin film made of $Sr_2 (Ta_{1-x}Nb_x)_2 0_7$ using the value x as a parameter. The axis of abscissas shows the voltages, and the axis of ordinates represents density of the leakage currents. The density of the leakage currents is the highest value when the value x is 0.3, and it becomes the lowest value when the value x is 0.1. The results might be caused by measurement error. In any case, the leakage current density is a relatively small value such as equal or less than $6X10^{-7}A/cm^2$ when a voltage 3V (in electric field equivalent of approximately 200KV/cm) is applied to the thin film.

Although, the thin film made of mixed crystal is designed so that Curie temperature Tc of which is in a range of $180°C \leq x \leq 600°C$ in the embodiments described above, Curie temperature of the thin film used in the present invention is not limited to this temperature range. A ferroelectric thin film having desired Curie temperature Tc corresponding to the temperature at which the device being in operation is preferred.

Though, the ferroelectric thin film according to the present invention is applied to the FET 20 having the MFMIS structure in the embodiments described above, the application of the present invention is not limited to FETs of only such structure. The present invention is also applicable to FETs having other structures, such as any of the FET 40 having MFIS structure shown in Fig. 12A, the FET 50 having the MIFIS structure shown in Fig. 12B, and the FET 60 having the MFS structure shown in Fig. 12C.

The FET 40 having the MFIS structure is considered as an equivalent circuit in which a capacitor including an insulation layer 42, another capacitor which comprises a ferroelectric thin film 44 is connected in series during the writing. The FET 50 having the MIFIS structure may also be considered as an equivalent circuit having a formation of connecting a capacitor which includes an insulation layer 52, another capacitor which comprises a ferroelectric thin film 54, and still another capacitor which includes an insulation layer 56 in series during the writing.

The FET 60 having the MFS structure further may be considered as an equivalent circuit in which a capacitor including an insulation layer 62 and another capacitor which comprises a ferroelectric thin film 64 is connected in series during the writing. The insulation layer 62 made of SiO2 is formed unintentionally during a process of depositing the ferroelectric thin film 64 on a semiconductor substrate 61 of silicon.

The application of the present invention is not limited to FETs including a ferroelectric thin film. The present invention may also be applicable to other types of memory devices including a first capacitor having a ferroelectric thin film and a second capacitor substantially connected to the first capacitor in series. In addition, the present invention is applicable generally to memory devices including a ferroelectric thin film.
Characteristic values of the ferroelectric layer such as dielectric constant, melting point Curie temperature (related to ferroelectricity) can be selected as desired according to the mixed crystal composition. In this way, a ferroelectric thin film having characteristics of desired ferroelectricity, a low dielectric constant, and a high melting point may be obtained.

The Curie temperature Tc of the ferroelectric thin film described herein is in a range of 180°C to 600°C. In this way, a ferroelectric thin film which shows stable ferroelectricity within an operating range of -50°C to +150°C can be obtained.

The ferroelectric memory device described hereinbefore includes a first capacitor having the ferroelectric thin film, and a second capacitor connected to the first capacitor substantially in series, and information is stored in accordance with a divided voltage applied to the ferroelectric thin film of the first capacitor by applying a voltage which corresponds to the information to be stored to the distal ends of the first capacitor and the second capacitor connected in series.

In other words, the information is stored in accordance with the divided voltage applied to the ferroelectric thin film of the first capacitor by applying a voltage corresponding to the information to the distal ends of the first capacitor and the second capacitor connected in series.

The divided voltage applied to the first capacitor can be increased using a ferroelectric thin film having a low dielectric constant. In this way, polarization reversal of the ferroelectric thin film can be caused easily during the writing. As a result, storing information into the ferroelectric memory device can be carried out easily.

Examples have been given of a ferroelectric memory device comprising a source region, a drain region, a channel region formed between the source region and the drain region, an insulation layer disposed on the channel region, a ferroelectric thin film disposed above the insulation layer, and a thin film conductive layer disposed on the ferroelectric thin film.

Therefore, the probability of lattice defects in a ferroelectric thin film once formed is decreased in an FET requiring heat treatment after forming the ferroelectric thin film by choosing a ferroelectric thin film having a high melting point. In this way, it is possible to obtain a ferroelectric memory device with high reliability.

In a preferred embodiment of the present invention, the ferroelectric memory device has a conductive layer between the insulation layer and the ferroelectric thin film. In this way, it is possible to obtain a ferroelectric memory device with much high reliability by fabricating it with a structure so called MFMIS (Metal Ferroelectric Metal Insulator Silicon).

The ferroelectric memory device in accordance with the present invention is characterized in that, the value of x of the aforesaid mixed crystal formula is in a range of 0.1 to 0.3. It is, therefore, possible to form a ferroelectric thin film which shows ferroelectricity at room temperature by controlling the mixture ratio of the mixed crystal within this range.

## Claims

**1.** A ferroelectric memory device (20; 40; 50; 60) including a ferroelectric thin film (F: 28; 44; 54; 64) by which information can be stored using its hysteresis characteristic, **characterized in that** the ferroelectric thin film (F: 28; 44; 54; 64) is composed of a mixed crystal defined by the formula:

$$Sr_2\ (Ta_{1-x}Nb_x)_2O_7;\ 0.1 \le x \le 0.3.$$

**2.** The ferroelectric memory device in accordance with claim 1, wherein the value of x is 0.3.

**3.** The ferroelectric memory device in accordance with claim 1, wherein the ferroelectric memory device (F: 28; 44; 54; 64) comprises:

a source region (S);
a drain region (D);
a channel region (CH) formed between said source region (S) and said drain region (D);
an insulation layer (24; 42; 52; 62) disposed on said channel region,
said ferroelectric thin film (F: 28; 44; 54; 64) disposed above said insulation layer (24; 42; 52; 62), and
a conductive layer (30; M; M; M) disposed on said ferroelectric thin film (F: 28; 44; 54; 64).

**4.** The ferroelectric memory device in accordance with claim 3, wherein the ferroelectric memory device (20) has a conductive layer (26) between said insulation layer (24) and said ferroelectric thin film (28).

**5.** The ferroelectric memory device in accordance with claim 1, wherein the ferroelectric memory device (20; 40; 50;

60) includes:

a first capacitor ($C_f$) having said ferroelectric thin film (F: 28; 44; 54; 64);
a second capacitor ($C_{ox}$) connected in series to said first capacitor ($C_f$); and
means of applying, to the distal ends of said first capacitor ($C_f$) and said second capacitor ($C_{ox}$) which are connected in series, a voltage (V) corresponding to information that is to be stored, to result in respective divided voltages ($V_f$, $V_{ox}$) being applied to the first capacitor ($C_f$) and to the second capacitor ($C_{ox}$), whereby information shall be stored in the ferroelectric memory device (20; 40; 50; 60) in accordance with the divided voltage ($V_f$) that is applied to the ferroelectric thin film (F: 28; 44; 54; 64) of the first capacitor ($C_f$).

**6.** A method of manufacturing the ferroelectric memory device (20; 40; 50; 60) of any one of claims 1-5, the method including producing a ferroelectric thin film (F: 28; 44; 54; 64) by performing ordered steps of

(a) coating a base with mixed-metal alkoxide of Sr, Ta, and Nb dissolved in a solvent;
(b) evaporating the solvent;
(c) removing the organic elements of the residue by heat treatment; and,
after performing steps (a) to (c) one or more times to form an amorphous thin film having a desired thickness:
(d) annealing said amorphous thin film at a temperature above crystallization point to form a thin film (F: 28; 44; 54; 64) of said mixed crystal defined by said formula: $Sr_2\ (Ta_{1-x}Nb_x)_2O_7$; $0.1 \le x \le 0.3$.

**Patentansprüche**

**1.** Eine ferroelektrische Speichervorrichtung (20; 40; 50; 60) beinhaltend eine ferroelektrische Dünnschicht (F: 28; 44; 54; 64), mit der Informationen unter Benutzung ihrer Hysterese-Charakteristik gespeichert werden können, **dadurch gekennzeichnet, dass** die ferroelektrische Dünnschicht (F: 28; 44; 54; 64) aus einem Mischkristall zusammengesetzt ist, der durch die Formel

$$Sr_2\ (Ta_{1-x}\ Nb_x)_2\ O_7;\ 0.1 \le x \le 0.3$$

definiert ist.

**2.** Die ferroelektrische Speichervorrichtung gemäß Anspruch 1, wobei der Wert von x 0.3 ist.

**3.** Die ferroelektrische Speichervorrichtung gemäß Anspruch 1, wobei die ferroelektrische Speichervorrichtung (F: 28; 44; 54; 64) aufweist:

einen Source-Bereich (S);
einen Drain-Bereich (D);
einen Kanalbereich (CH), der zwischen dem Source-Bereich (S) und dem Drain-Bereich (D) ausgebildet ist;
eine Isolierschicht (24; 42; 52; 62), abgelagert auf dem Kanalbereich,
wobei die ferroelektrische Dünnschicht (F: 28; 44; 54; 64) über der Isolierschicht (24; 42; 52; 62) abgelagert ist, und
eine leitfähige Schicht (30; M; M; M) auf der ferroelektrischen Dünnschicht (F: 28; 44; 54; 64) abgelagert ist.

**4.** Die ferroelektrische Speichervorrichtung gemäß Anspruch 3, wobei die ferroelektrische Speichervorrichtung (20) eine leitfähige Schicht (26) zwischen der Isolierschicht (24) und der ferroelektrischen Dünnschicht (28) aufweist.

**5.** Die ferroelektrische Speichervorrichtung gemäß Anspruch 1, wobei die ferroelektrische Speichervorrichtung (20; 40; 50; 60) beinhaltet:

eine erste Kapazität ($C_f$), welche die ferroelektrische Dünnschicht (F: 28; 44; 54; 64) aufweist;
eine zweite Kapazität ($C_{ox}$), die in Reihe mit der ersten Kapazität ($C_f$) geschaltet ist; und
Mittel zum Anlegen einer Spannung (V), die den Informationen entspricht, die gespeichert werden sollen, an die distalen Enden der ersten Kapazität ($C_f$) und der zweiten Kapazität ($C_{ox}$), die in Reihe geschaltet sind, um jeweilige geteilte Spannungen ($V_f$, $V_{ox}$) zu ergeben, die an die erste Kapazität ($C_f$) und an die zweite Kapazität ($C_{ox}$) angelegt werden, mit denen Informationen in der ferroelektrischen Speichervorrichtung (20; 40; 50; 60) gespeichert werden sollen in Übereinstimmung mit der geteilten Spannung ($V_f$), die an die ferroelektrische Dünnschicht (F: 28; 44; 54; 64) der ersten Kapazität ($C_f$) angelegt wird.

6. Ein Verfahren zum Herstellen der ferroelektrischen Speichervorrichtung (20; 40; 50; 60) gemäß einem der Ansprüche 1 bis 5, wobei das Verfahren beinhaltet ein Herstellen einer ferroelektrischen Dünnschicht (F: 28; 44; 54; 64) durch Ausführen von geordneten Schritten des

(a) des Beschichtens einer Basis mit einem gemischtmetallischen Alkoxid aus Sr, Ta und Nb gelöst in einem Lösungsmittel;
(b) des Verdampfens des Lösungsmittels;
(c) des Entfernens der organischen Elemente des Rückstands einer Hitzebehandlung; und
nach Ausführen der Schritte (a) bis (c) ein oder mehre Male zum Ausbilden einer amorphen Dünnschicht, die eine gewünschte Dicke besitzt:
(d) des Ausheilens der amorphen Dünnschicht bei einer Temperatur über dem Kristallisationspunkt zum Ausbilden einer Dünnschicht (F: 28; 44; 54; 64) des Mischkristalls definiert durch die Formel: $Sr_2\ (Ta_{1-x}\ Nb_x)_2O_7$; $0.1 \leq x \leq 0.3$.

## Revendications

1. Dispositif de mémoire ferroélectrique (20 ; 40 ; 50 ; 60) incluant un film mince ferroélectrique (F : 28 ; 44 ; 54 ; 64) par l'intermédiaire duquel des informations peuvent être mémorisées en utilisant sa caractéristique d'hystérésis, **caractérisé en ce que** le film mince ferroélectrique (F : 28 ; 44; 54 ; 64) est constitué d'un cristal mixte défini par la formule:

$$Sr_2\ (Ta_{1-x}\ Nb_X)_2\ O_7\ ;\ 0,\ 1 \leq x \leq 0,3$$

2. Dispositif de mémoire ferroélectrique selon la revendication 1, dans lequel la valeur de x est 0,3.

3. Dispositif de mémoire ferroélectrique selon la revendication 1, dans lequel le dispositif de mémoire ferroélectrique (F : 28 ; 44 ; 54 ; 64) comporte :

une zone de source (S),
une zone de drain (D),
une zone de canal (CH) formée entre ladite zone de source (S) et ladite zone de drain (D),
une couche d'isolation (24 ; 42 ; 52 ; 62) disposée sur ladite zone de canal,
ledit film mince ferroélectrique (F : 28; 44 ; 54 ; 64) disposé au-dessus de ladite couche d'isolation (24 ; 42 ; 52; 62), et
une couche conductrice (30 ; M ; M ; M) disposée sur ledit film mince ferroélectrique (F : 28 ; 44 ; 54 ; 64).

4. Dispositif de mémoire ferroélectrique selon la revendication 1, dans lequel le dispositif de mémoire ferroélectrique (20) a une couche conductrice (26) entre ladite couche d'isolation (24) et ledit film mince ferroélectrique (28).

5. Dispositif de mémoire ferroélectrique selon la revendication 1, dans lequel le dispositif de mémoire ferroélectrique (20 ; 40 ; 50 ; 60) comporte :

un premier condensateur ($C_f$) ayant ledit film mince ferroélectrique (F : 28 ; 44 ; 54 ; 64),
un second condensateur ($C_{ox}$) connecté en série audit premier condensateur ($C_f$), et
des moyens pour appliquer, aux extrémités distales dudit premier condensateur ($C_f$) et dudit second condensateur ($C_{ox}$) qui sont connectés en série, une tension (V) correspondant à des informations qui doivent être mémorisées, pour avoir pour résultat des tensions divisées respectives ($V_f$, $V_{ox}$) appliquées au premier condensateur ($C_f$) et au second condensateur ($C_{ox}$), de sorte que les informations peuvent être mémorisées dans le dispositif de mémoire ferroélectrique (20 ; 40 ; 50 ; 60) selon la tension divisée ($V_f$) qui est appliquée au fil mince ferroélectrique (F : 28 ; 44 ; 54 ; 64) du premier condensateur ($C_f$).

6. Procédé pour fabriquer le dispositif de mémoire ferroélectrique (20 ; 40 ; 50 ; 60) selon l'une quelconque des revendications 1 à 5, le procédé comprenant la production d'un film mince ferroélectrique (F : 28 ; 44 ; 54 ; 64) en effectuant les étapes ordonnées consistant à :

(a) recouvrir une base d'un alcoxyde métallique mixte Sr, Ta et Nb dissous dans un solvant,
(b) évaporer le solvant,
(c) enlever les éléments organiques du résidu par un traitement thermique, et,
après avoir effectué les étapes (a) à (c) une ou plusieurs fois pour former un film mince amorphe ayant une épaisseur souhaitée :
(d) recuire ledit film mince amorphe à une température au-dessus du point de cristallisation pour former un film mince (F : 28 ; 44 ; 54 ; 64) dudit cristal mixte défini par ladite formule : $Sr_2 (Ta_{1-x} Nb_x)_2 O_7$; $0,1 \leq x \leq 0,3$.

FIG.1

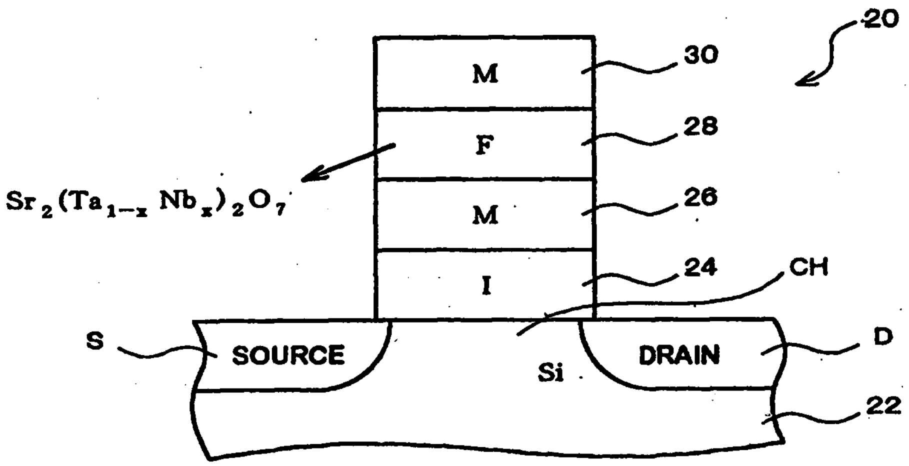


20:FET
22:SILICON SEMICONDUCTOR SUBSTRATE
24:GATE OXIDATION LAYER
26:FLOATING GATE
28:FERROELECTRIC LAYER
30:CONTROL GATE
CH:CHANNEL REGION

FIG.2

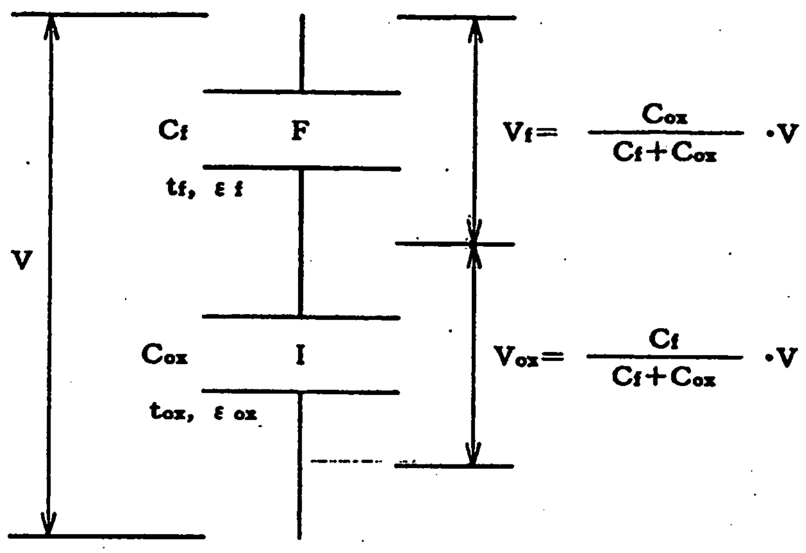
V
$C_f$
F
$t_f$, $\varepsilon_f$
$C_{ox}$
I
$t_{ox}$, $\varepsilon_{ox}$
$V_f = \frac{C_{ox}}{C_f + C_{ox}} \cdot V$
$V_{ox} = \frac{C_f}{C_f + C_{ox}} \cdot V$

FIG.3

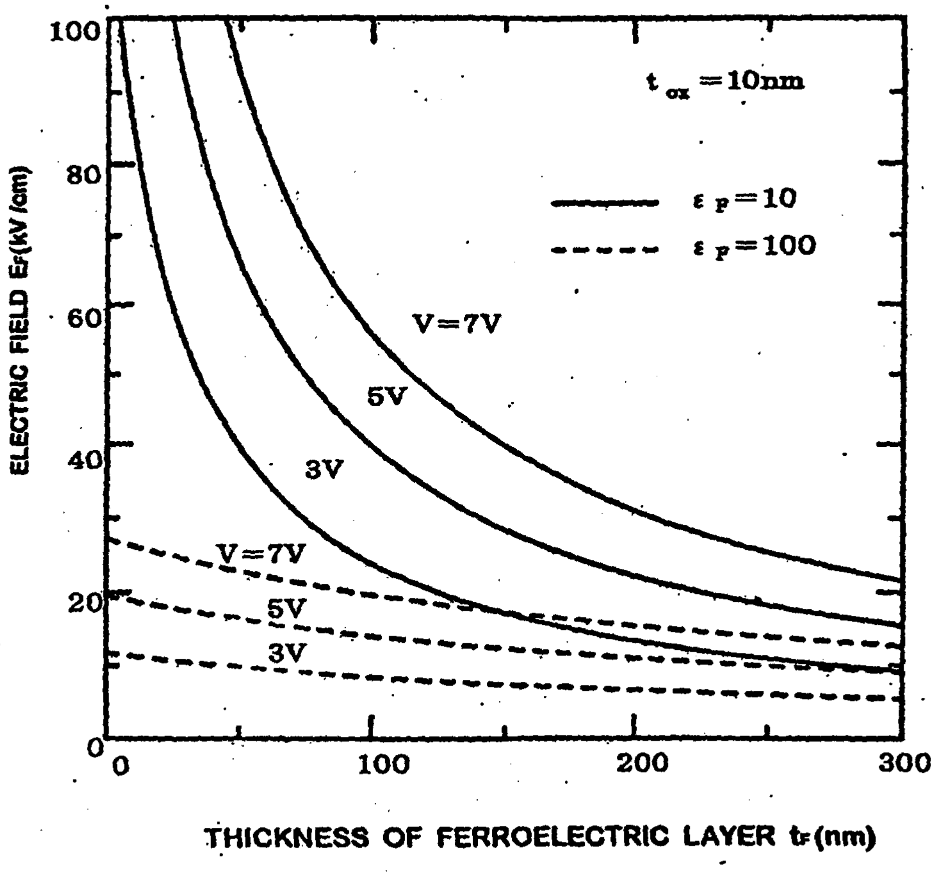
100
80
60
40
20
0
ELECTRIC FIELD Ef(kV/cm)
0
100
200
300
THICKNESS OF FERROELECTRIC LAYER tF(nm)
t ox =10nm
ε F=10
ε F=100
V=7V
5V
3V
V=7V
5V
3V

FIG.4A

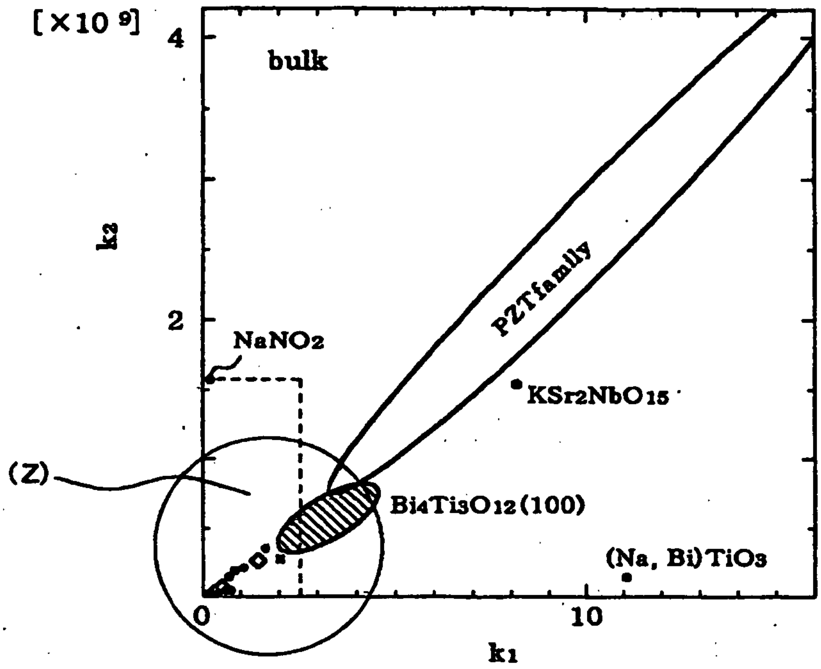
[×10 9]
4
2
0
10
bulk
k2
k1
PZT family
NaNO2
KSr2NbO15
(Z)
Bi4Ti3O12 (100)
(Na, Bi) TiO3

FIG.4B

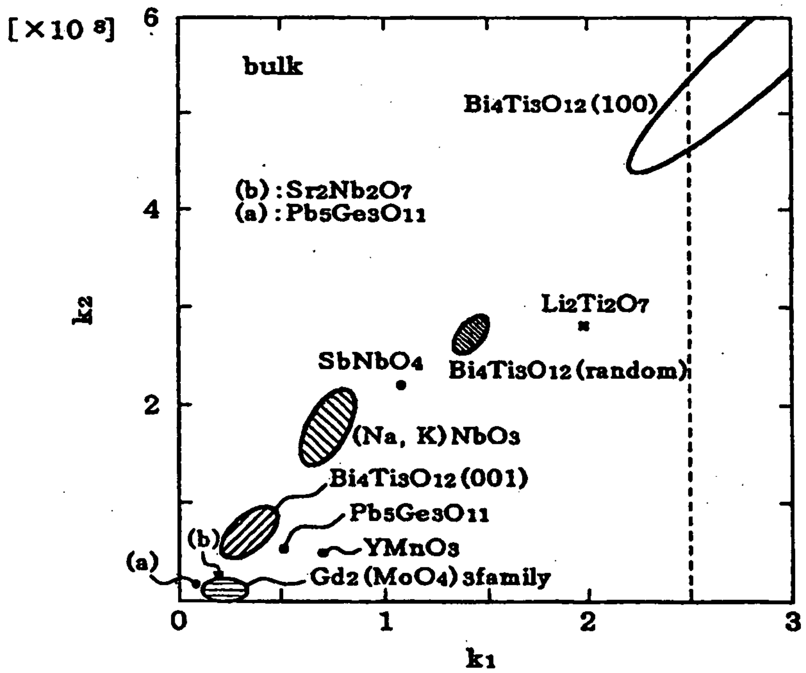
[×10 8]
6
4
2
0
1
2
3
bulk
k2
k1
Bi4Ti3O12 (100)
(b) : Sr2Nb2O7
(a) : Pb5Ge3O11
Li2Ti2O7
SbNbO4
Bi4Ti3O12 (random)
(Na, K) NbO3
Bi4Ti3O12 (001)
Pb5Ge3O11
YMnO3
(b)
(a)
Gd2 (MoO4) 3family

FIG.5

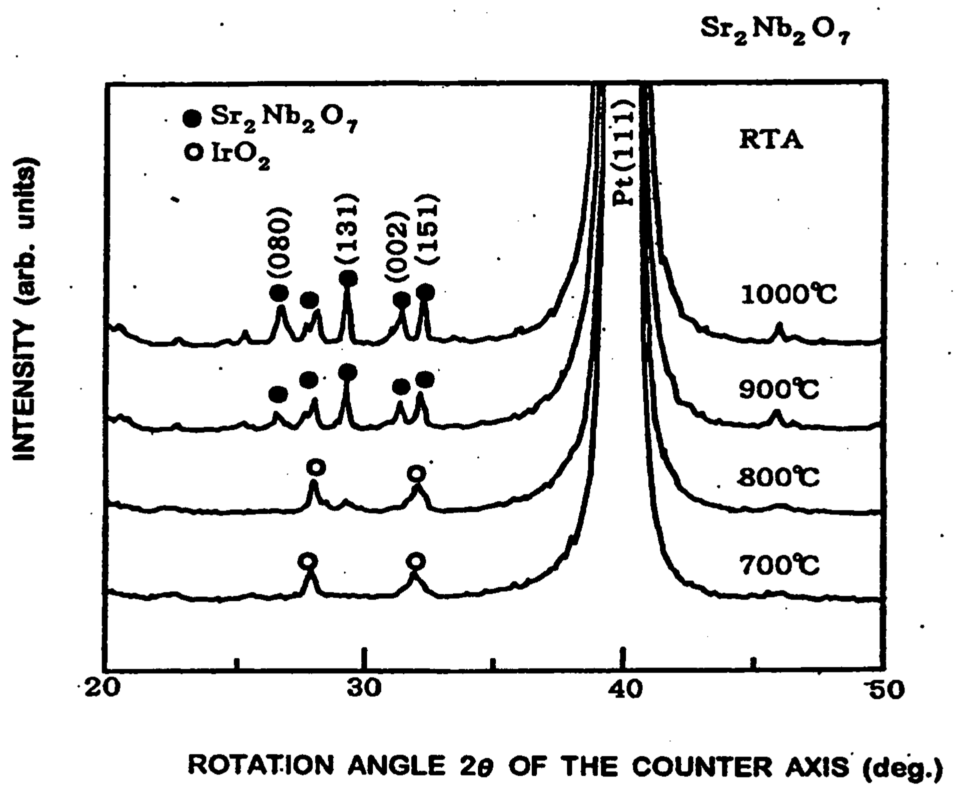
Sr$_2$Nb$_2$O$_7$
● Sr$_2$Nb$_2$O$_7$
○ IrO$_2$
(080)
(131)
(002)
(151)
Pt(111)
RTA
1000℃
900℃
800℃
700℃
INTENSITY (arb. units)
20
30
40
50
ROTATION ANGLE 2θ OF THE COUNTER AXIS (deg.)

# FIG.6

| | | $Sr_2Nb_2O_7$ | $Sr_2Ta_2O_7$ |
|---|---|---|---|
| CRYSTAL STRUCTURE | | PYRAMID QUADRATIC | PYRAMID QUADRATIC |
| LATTICE CONSTANT | a (Å) | 3. 993 | 3. 937 |
| LATTICE CONSTANT | b (Å) | 26. 726 | 27. 198 |
| LATTICE CONSTANT | c (Å) | 5. 683 | 5. 692 |
| MELTING POINT | $T_m$ (℃) | 1700 | 2000 |
| CURIE TEMPERATURE | $T_c$ (℃) | 1342 | −107 |
| REMANENT POLARIZATION | $P_r$ ($\mu C/cm^2$) | 9 | 1. 9 [a)] |
| COERCIVE FIELD | $E_c$ (kV/cm) | 6 | 0. 4 [a)] |
| RELATIVE DIELECTRIC CONSTANT | $\varepsilon_a$ | 75 | 37 |
| RELATIVE DIELECTRIC CONSTANT | $\varepsilon_b$ | 46 | 22 |
| RELATIVE DIELECTRIC CONSTANT | $\varepsilon_c$ | 43 | 644 |

CRYSTALLOGRAPHIC AND ELECTRIC CHARACTERISTICS OF $Sr_2Nb_2O_7$, $Sr_2Ta_2O_7$

a) AT A TEMPERATURE OF LIQUID NITROGEN

# FIG.7

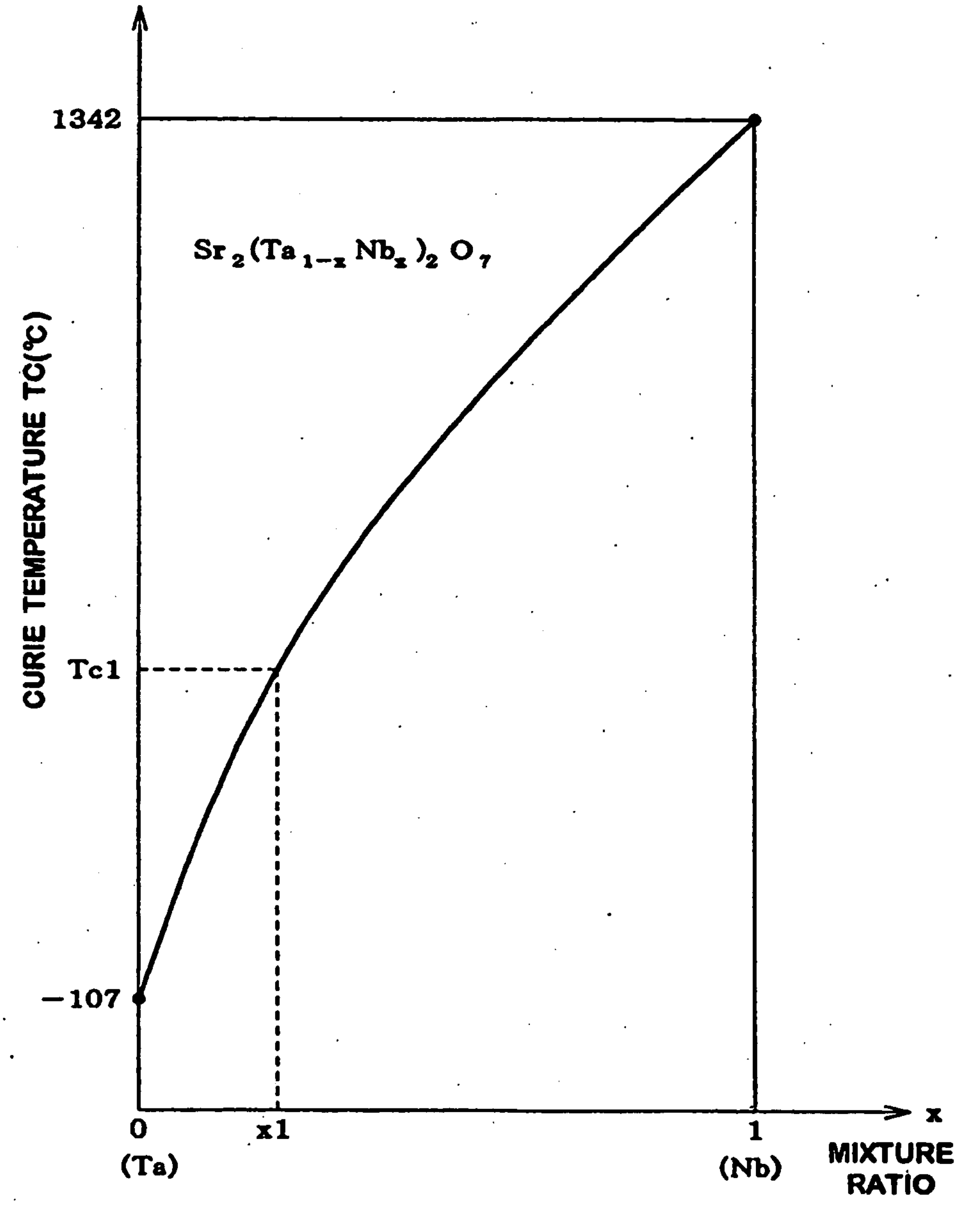
1342
$Sr_2(Ta_{1-x}Nb_x)_2O_7$
CURIE TEMPERATURE TC(℃)
Tc1
−107
0
(Ta)
x1
1
(Nb)
x
MIXTURE RATIO

FIG.8

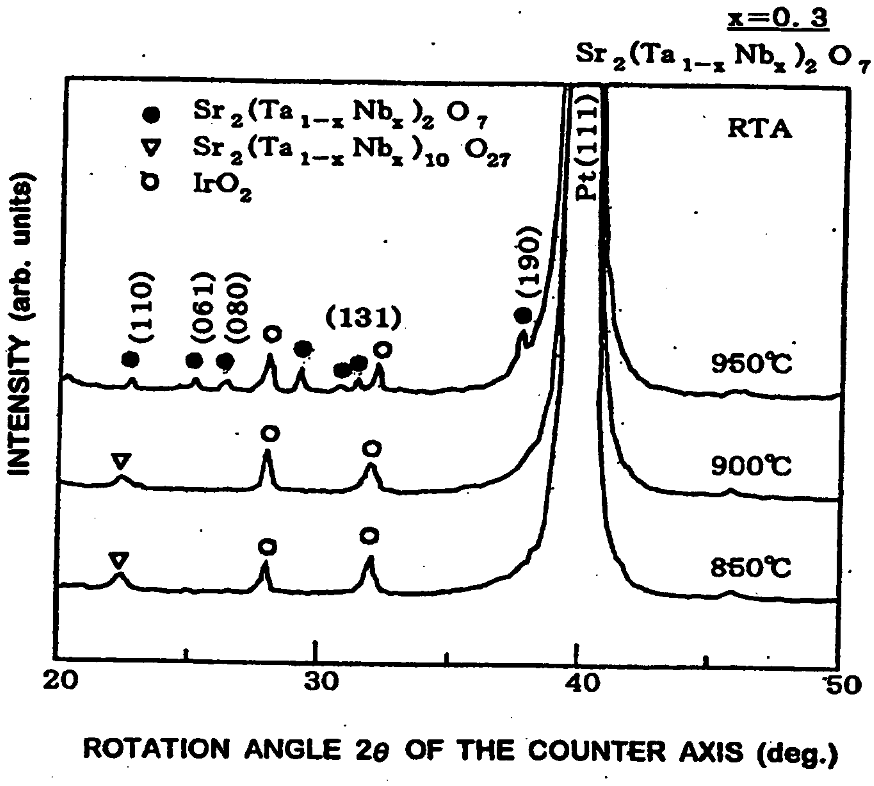
x=0. 3
$Sr_2(Ta_{1-x}Nb_x)_2O_7$
● $Sr_2(Ta_{1-x}Nb_x)_2O_7$
▽ $Sr_2(Ta_{1-x}Nb_x)_{10}O_{27}$
○ $IrO_2$
RTA
Pt(111)
(110)
(061)
(080)
(131)
(190)
950℃
900℃
850℃
INTENSITY (arb. units)
20
30
40
50
ROTATION ANGLE 2θ OF THE COUNTER AXIS (deg.)

# FIG.9

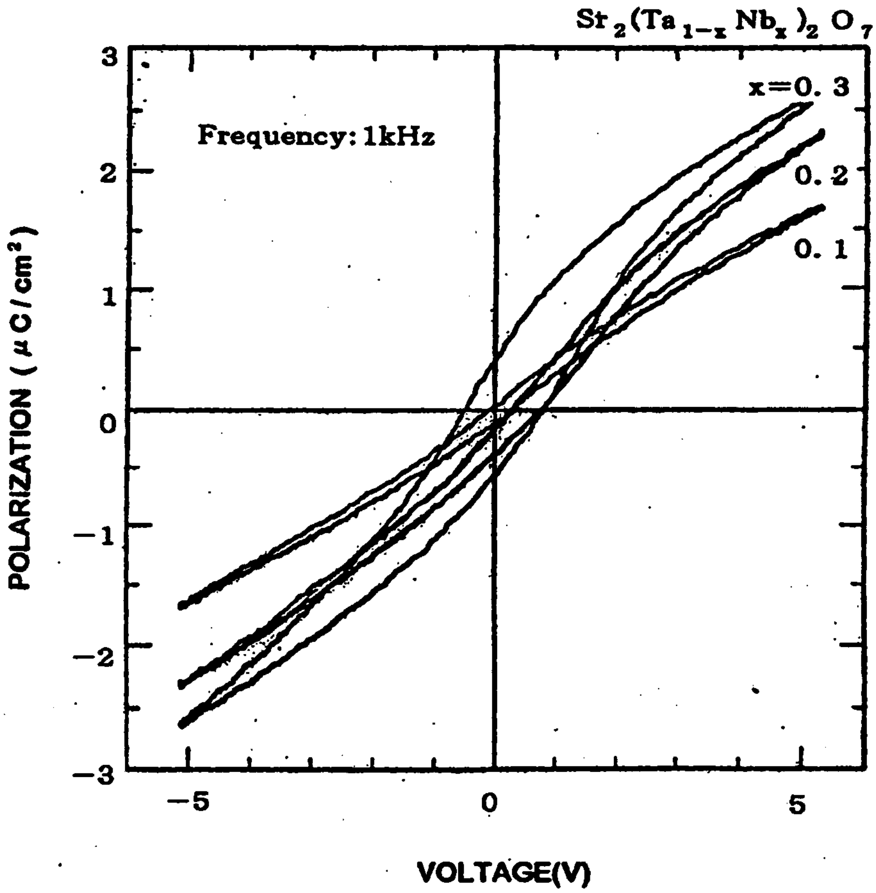

$Sr_2(Ta_{1-x}Nb_x)_2O_7$
Frequency: 1kHz
x=0. 3
0. 2
0. 1
POLARIZATION ( μC/cm²)
3
2
1
0
−1
−2
−3
−5
0
5
VOLTAGE(V)

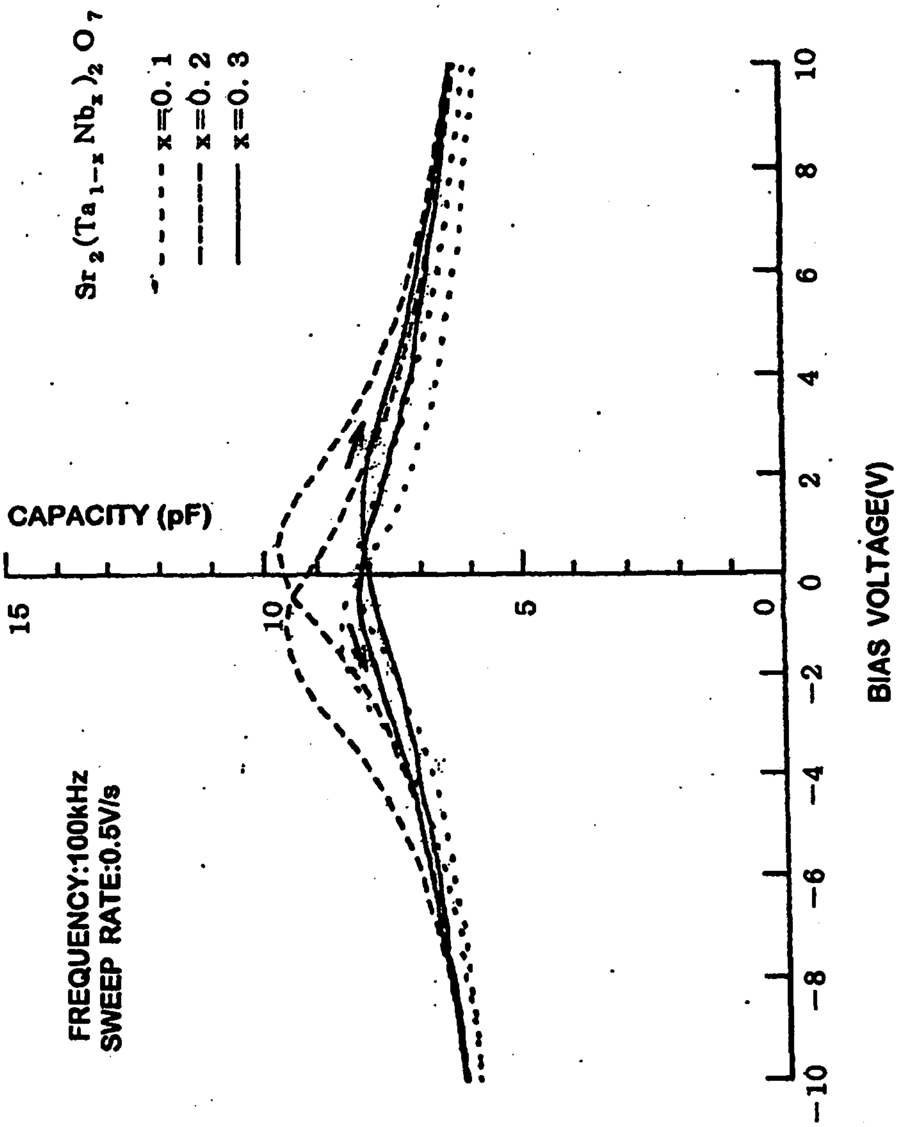
CAPACITY (pF)
15
10
5
0
BIAS VOLTAGE(V)
−10
−8
−6
−4
−2
0
2
4
6
8
10
FREQUENCY:100kHz
SWEEP RATE:0.5V/s
$Sr_2(Ta_{1-x}Nb_x)_2O_7$
x=0. 1
x=0. 2
x=0. 3

FIG.10

FIG.11

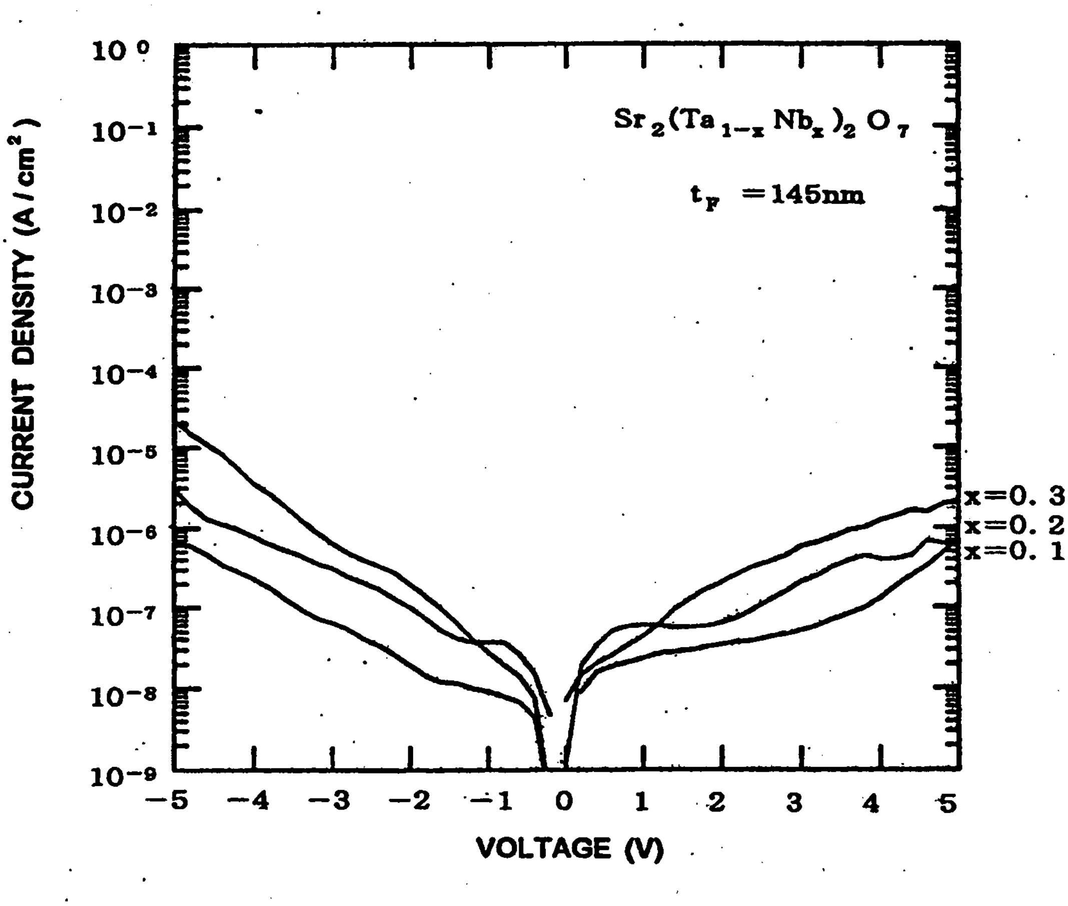

10 0
10−1
10−2
10−3
10−4
10−5
10−6
10−7
10−8
10−9
CURRENT DENSITY (A/cm²)
Sr2(Ta1−x Nbx)2 O7
tF =145nm
x=0. 3
x=0. 2
x=0. 1
−5
−4
−3
−2
−1
0
1
2
3
4
5
VOLTAGE (V)

FIG.12A

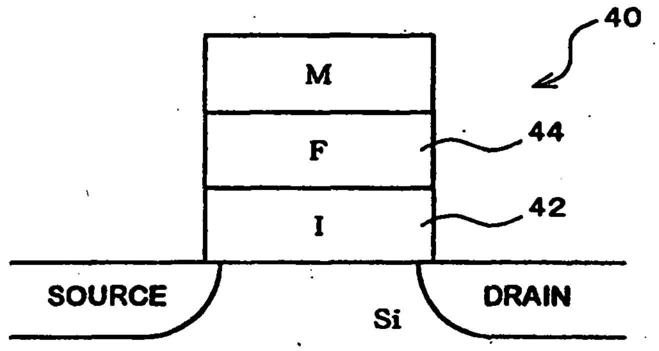


FIG.12B

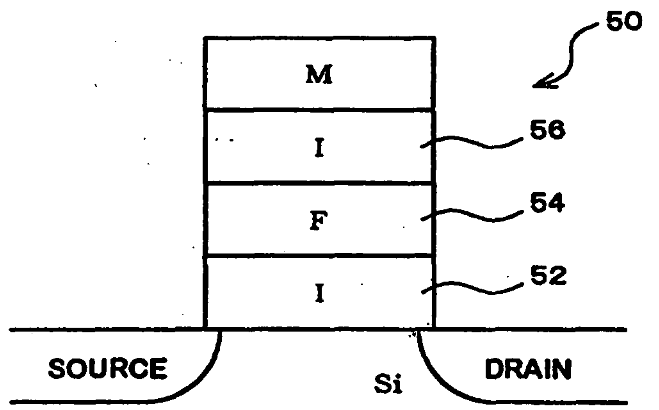


FIG.12C

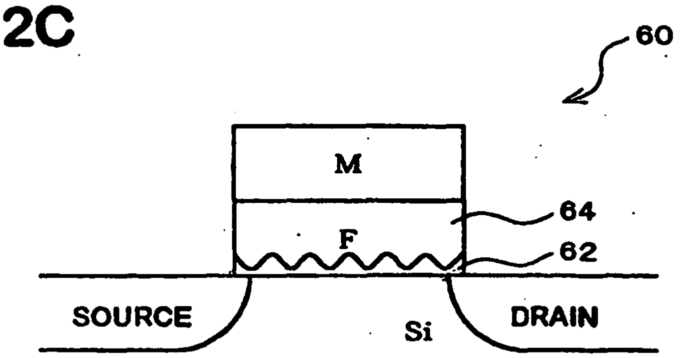

FIG.13

<PRIOR ART>

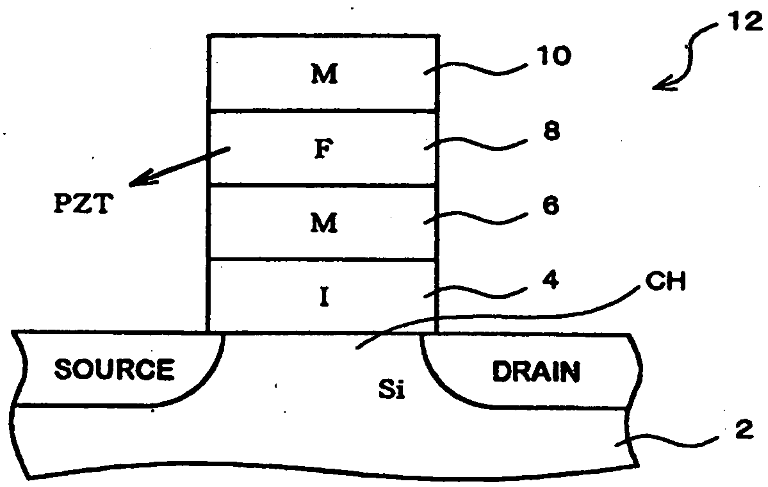

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 5365094 A

### Non-patent literature cited in the description

- **FUIERER P A et al.** Physical electric and piezoelectric properties of hot-forged Sr/sub2/(NbTa)/sub 2/O/sub 7/ceramics. *SMART MATERIALS FABRICATION AND MATERIALS FOR MICRO-ELECTRO-MECHANICAL SYSTEMS,* 28 April 1992, 51-57